# EUROPEAN PATENT SPECIFICATION

(11) **EP 0 638 213 B1**
(45) Date of publication and mention of the grant of the patent: **06.03.1996**
(21) Application number: 93911905.3
(22) Date of filing: 30.04.1993
(51) Int. Cl.: H03M 5/12, G11B 20/14

(54) **DATA SIGNAL DECODING DEVICE**
DATENSIGNALDEKODIERUNGSVORRICHTUNG
DISPOSITIF DE DECODAGE D'UN SIGNAL DE DONNEES

(30) Priority: 01.05.1992 GB 9209535
(43) Date of publication of application: 15.02.1995
(73) Proprietor: QUESTECH LIMITED, Wokingham Berkshire RG11 2PP (GB)
(72) Inventor: DAVIES, Trevor 23 Imperial Court Station Approach, Oxfordshire RG9 1NP (GB)
(74) Representative: Bubb, Antony John Allen
(86) International application number: GB9300911
(87) International publication number: WO9322841

(56) References cited:
- EP-A- 0 012 880
- EP-A- 0 222 132
- FR-A- 2 635 606
- US-A- 3 949 313
- US-A- 4 626 670

## Description

This invention relates to a device for decoding a data signal and, more especially, to a device for use in decoding a so-called bi-phase mark encoded serial data signal at a varying repetition rate of the signal.

A so-called bi-phase mark signal is a signal that switches between two states at intervals which may define short or long time periods. For decoding of the signal means is required for distinguishing short or long periods between transitions of the signal. The two states of the signal are usually determined as the two possible polarities of a balanced pair of lines with respect to each other. The coded signal may, for example, be divided into regular intervals called cells, each cell carrying one bit of data. Data are encoded by the presence or absence of a transition in the signal within each cell. Thus, each data cell may comprise a long period between two transitions of the signal, representing a cell containing no transition, or two short periods in a row which represent the two parts of a cell with a transition in the middle. The first case represents a zero and the second a one.

A bi-phase mark encoded serial data signal is used, for example, for the provision of linear time code (ltc) from a video tape recorder. Thus, the repetition rate of the cells of the linear time code will vary when the video tape recorder is operated at different speeds and an appropriate decoding means must therefore adapt to different speeds of the video tape recorder, even when the tape is speeding up or slowing down. Hitherto known circuits for performing this function are relatively expensive.

FR-A-2 635 606 discloses a device for decoding a bi-phase mark encoded serial data signal in which sampling pulses occurring between subsequent signal transitions are counted to obtain a count value proportional to the period between consecutive signal transitions. This proportional value is then compared against a reference value representing a mean count value of short and long periods.

It is an object of the present invention to provide a device for use in decoding a bi-phase mark encoded signal that will meet existing requirements while being of relatively inexpensive construction.

In accordance with the present invention there is provided a device for use in decoding a data signal of the kind which is divided into short and long periods between distinct transitions in state of the signal, comprising means for detecting transitions in the signal state, means coupled to said detecting means for providing an output signal having a value proportional to the period between consecutive signal transitions, means for providing a reference value representing the mean of a short and a long period of said signal, means for comparing the value of said proportional output signal with said reference value and for scaling the proportional value by a factor determined in accordance with the relationship between the said proportional and reference values, in order to increase the value of a said proportional signal corresponding to a short period and to reduce the value of a said proportional signal corresponding to a long period, in each case to a value corresponding to the mean of a short and a long period; and means for processing the said scaled values to derive said reference value.

A device in accordance with the invention may be implemented relatively inexpensively in digital form, and can accommodate variations in the repetition rate of a data signal, since the reference value against which short and long periods of the signal are distinguished is regularly updated in a recursive loop in which the reference value is generated from values measured from the incoming signal.

Preferably the means for processing the scaled values comprises a low pass filter for filtering the said scaled values to remove short term variations therein and to provide an average of the filtered signals, and means for providing the output signal of said filter to the said comparing means, as said reference value.The presence of the signal filter thus prevents the operation of the circuit from being disturbed by short term variations in the incoming signal caused, for example, by jitter.

The invention also provides a data extraction circuit in which the extraction of data from the incoming signal is effected in a relatively simple manner by logically combining the output signals from the transition detecting means and the comparator, in order, for example, to clock single bit data values into a shift register. A preferred embodiment of the invention accordingly incorporates a corresponding data extracting logic circuit.

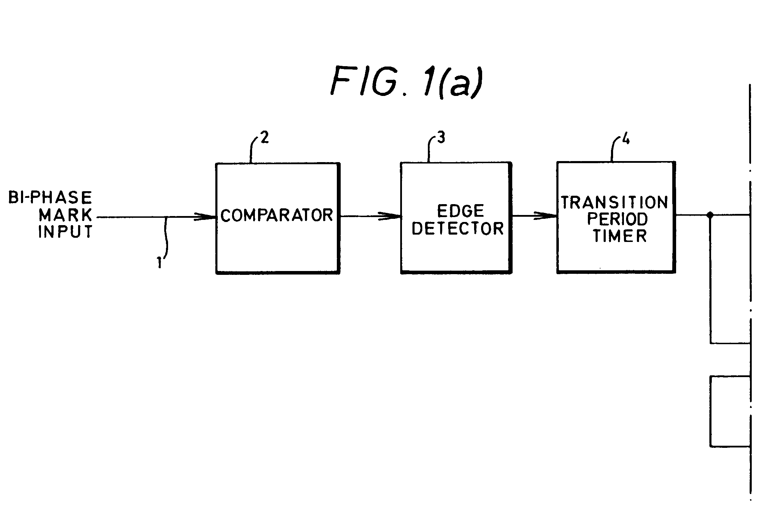

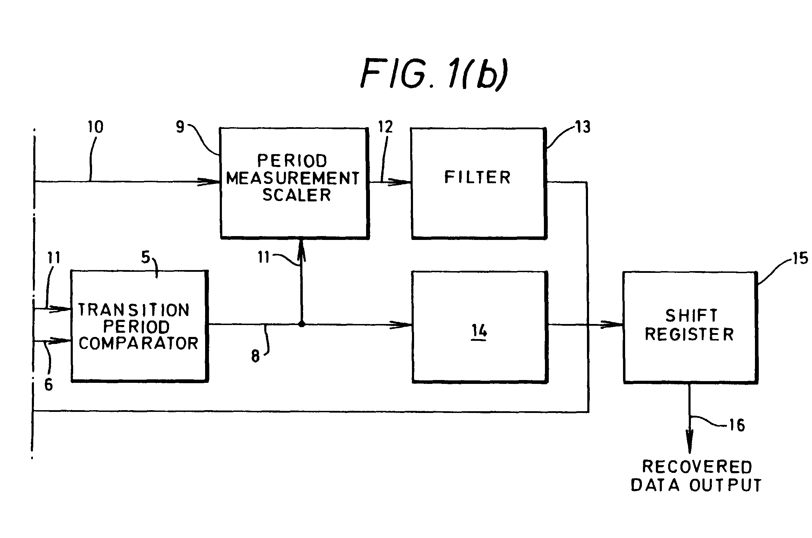

Further preferred features and advantages of the invention will become apparent from the following description taken in conjunction with the accompanying drawings, in which;
Figure 1 is a block circuit diagram of a data signal decoding device in accordance with the invention,
Figure 2 is a more detailed circuit diagram of one implementation of the device illustrated in Fig. 1,
Figure 3 is a block circuit diagram of one element of the device of Fig. 2,
Figure 4 is a diagram illustrating the relationship between wave forms occurring in the circuits of Figs. 2 and 3, and
Figure 5 is a diagram illustrating possible transitions between states of the circuit of Fig. 3 in response to incoming signal values.
Referring to Fig. 1 of the drawings, a device in accordance with the invention incorporates an input 1 for receiving a bi-phase mark encoded signal. Although the input is illustrated as a single line, it will be appreciated that the input comprises a balanced pair of lines of which the polarity will change at transitions of the signal.

Likewise, it will be appreciated that the remaining signal paths indicated in Fig. 1 by single lines will, in practice, include a number of signal paths appropriate to the signals to be transmitted.

A comparator 2 is coupled to the signal input 1 in order to detect the instantaneous state of an input signal. An edge detector 3 is coupled to the output of the comparator 2 in order to generate a pulse corresponding to the transition between the two states of an incoming signal. A transition period timer 4 coupled to the edge detector 3 is arranged to measure the period of time between each consecutive pair of edge detector pulses and to provide an output signal having a corresponding value.

A transition period comparator 5 has a first input 6 that is arranged to receive a value, derived in a manner to be described below, that is a mean value of a long period between two transition states of the incoming bi-phase signal, and a short period of the same signal. A second input 7 of the comparator 5 is coupled to the output of the transition period timer, and the latter is arranged to provide at an output 8 a signal having a first state when the value received on input 7 is less than that received on input 6 and a second state when the value received on input 7 is greater than that received on input 6. Thus the first and second states of the signal from the comparator 5 indicate respectively short and long periods of time between consecutive transitions of the incoming signal.

A period measurement scaler 9 has a first input 10 coupled to the output of the transition period timer 4 and a second input 11 coupled to the output 8 of the transition period comparator 5. The period measurement scaler 9 is arranged to provide at an output 12 a value which represents the incoming value received from the transition period timer 4 scaled by a factor determined in accordance with the state of the signal received on input 11. Thus, for example, assuming that a long period between transitions of the incoming signal is equal to twice the duration of a short period, as in the case of an encoded signal of the kind initially described above, the value received at input 10 is scaled by the factor 3/2 when the signal at input 11 is in the tirst state, and is scaled by the factor 3/4 when the signal received at input 11 is in the second state. This accordingly has the result that incoming signal values are increased or reduced as necessary in each case to bring the value at output 12 to a mean value lying between the values of short and long periods of time respectively.

The output 12 of the scaler 9 is coupled to an input of a low pass filter 13, of which the output is coupled to the input 6 of the transition period comparator 5. The filter 13 generates the average of the mean values provided at output 12 for recent periods measured, and this average value is thus used as the reference for the transition period comparator 5. The filter result follows changes in the speed of the bi-phase mark signal but filters out short term variations such as jitter.

Thus, the state of the signal at the output 8 of the transition period comparator reliably indicates the existence of a long or short period of time between transitions of the incoming signal. The state of this signal can be used directly for the recovery of data from the incoming signal, by determining the presence of a single long period of time, or two consecutive short periods of time. This determination can be effected by a logic circuit 14 of which the output is coupled to a shift register 15 providing recovered data at an output 16.

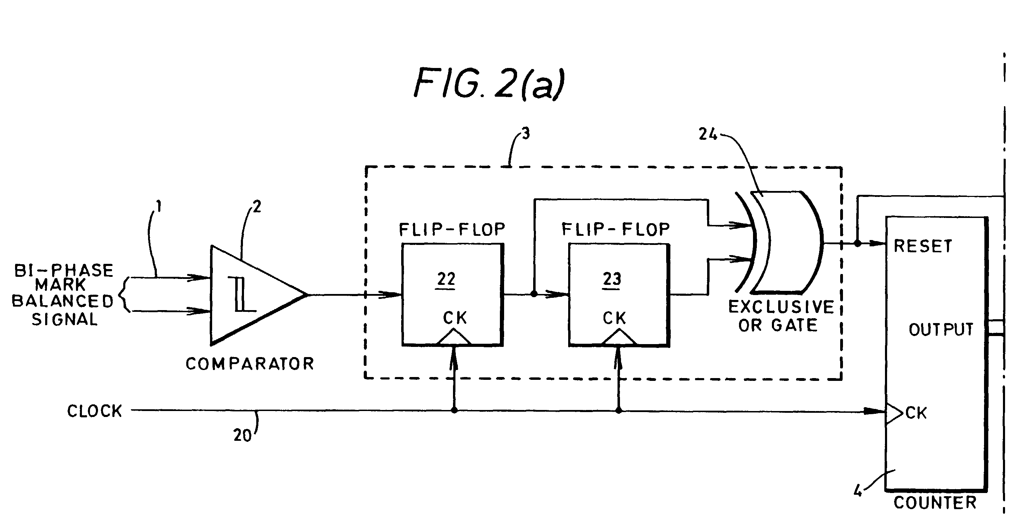

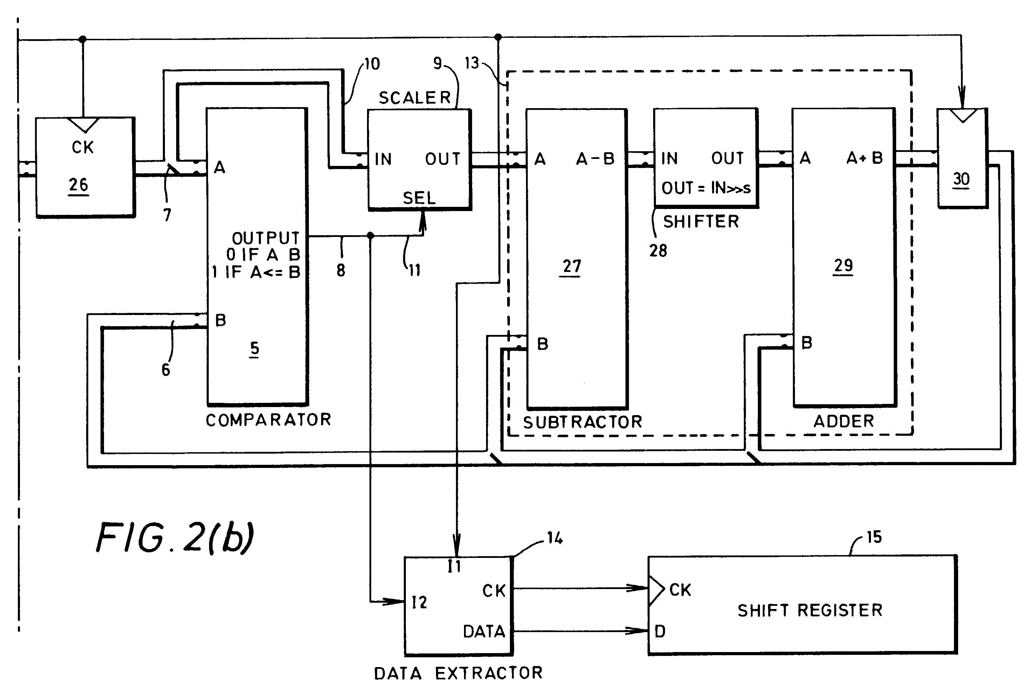

Although the device described above may be implemented in several ways, there is illustrated in Fig. 2 one particular design providing for digital processing of the incoming signal. In Fig. 2, individual components corresponding to those of Fig. 1 have been indicated with the same reference numerals, and in the case where an individual box of Fig. 1 has been replaced by a number of discrete components, the corresponding group of components has been contained in a box indicated in broken lines and having the same reference numeral as the corresponding element of Fig. 1.

In Fig. 2, there is provided at input 20 a clock signal that has a frequency more than twice the highest frequency that will be present in the incoming bi-phase signal under any condition of operation of the device. The signal paths indicated in Fig. 2 in single lines indicate binary digital signal paths, whereas the multiple signal paths comprise digital signal buses of 'N' bits, where N is selected to suit the range of speeds of the incoming signal that are to be decoded.

The overall function of the device illustrated in Fig. 2 is the same as that of Fig. 1, and thus this will not be described again in detail. The variations in the individual components following from the digital implementation of the device will be outlined as follows.

### Comparator 2.

The balanced pair of lines from input 1 are fed into a voltage comparator 2 with some hysteresis (positive feedback) to give improved noise immunity. The output of the comparator is high or low depending on which of the lines is at the higher voltage.

### Edge detector 3.

The output of the comparator 2 is fed through two flip-flops 22 and 23 in succession clocked from the input 20. The two outputs are then logically combined in an exclusive OR gate 24 to give a pulse that occurs on both high to low and low to high transitions of the comparator output.

### Transition period timer 4.

This is a digital counter clocked by the input 20 and reset by the output pulse from gate 24. The counter stops if it ever reaches its maximum expressible number and the count is held in a latch 26 just before it is reset. The number of bits required for this counter is determined by the range of speed of signal that the circuit must be able to decode. The theoretical minimum number of bits for a constant speed decoder would be one and this must double for a range from one speed to twice that speed and double again for every two fold increase in range. However to cope with real signals which contain some jitter and which may vary from the expected frequency at least one extra bit is required in practice.

### Transition period comparator 5.

The output from the latch 26 is compared to the output of the filter 13. The output is O if the value at input 7 is greater than that at input 6 and 1 if the value at input 6 is greater.

### Period measurement scaler 9.

The output of latch 26 is scaled by 3/2 by adding it to itself shifted right one place. This is then shifted right a further place if the comparator output is O or else passed on without further change.

### Filter 13.

This is an infinite impulse response filter comprising a subtractor 27, a shifter 28 and an adder 29. The filter result is subtracted from the scaled period at 27 and the difference is then right shifted at 28 and added to the filter result at 29 to form the new filter result which is latched into a latch 30 by the pulses from the gate 24. The number of places by which the difference is shifted sets how quickly the filter output will respond to a change in the signal speed.

### Data extractor 14.

The data extractor generates a one bit data stream and an accompanying clock from the outputs of the comparator 5 and the gate 24. Defining a long period as one which is larger than the filter result and short period as one which is shorter: a data bit of zero is generated for a long period and a data bit of one for two successive short periods. Both data bits are propagated with a clock which goes low to high once when the data are stable.

### Shift Register 15.

The data from the data extractor are clocked into the shift register by the clock from the data extractor. The shift register allows the decoded word to be interfaced to further circuitry such as a microprocessor or a display.

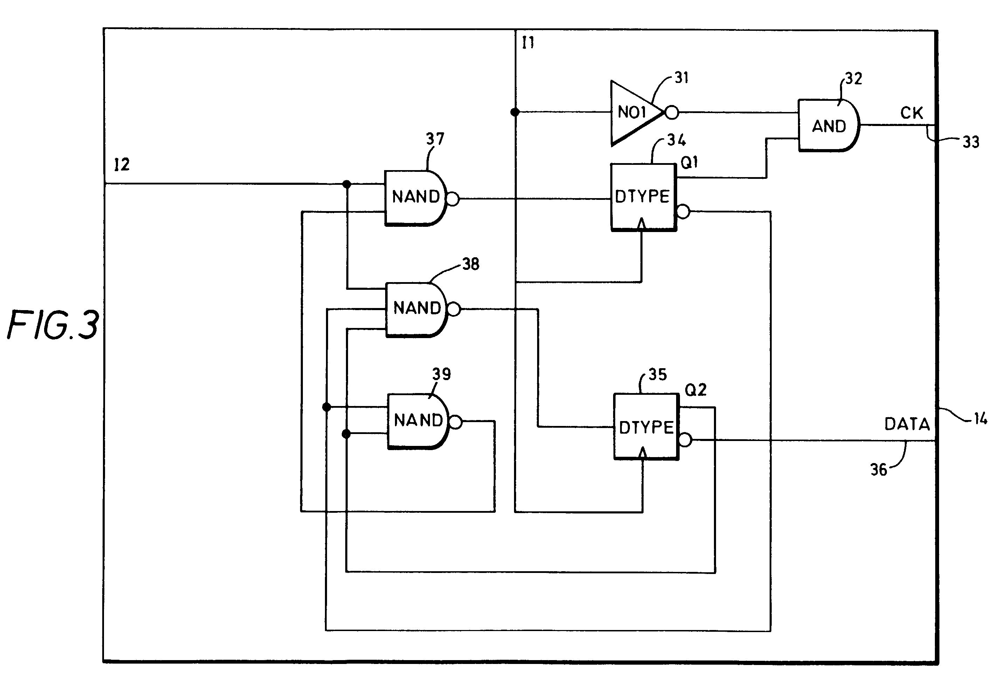

The operation of the data extractor 14 will now be described in more detail with reference to Figs. 3 to 5.

In Fig. 3, the box 14 represents the data extractor illustrated in Figs. 1 and 2, an input I1 being the input coupled to the gate 24 of Fig. 2, and an input I2 being the input coupled to the output 8 of the comparator 5.

The input I1 is coupled via a NOT gate 31 and an AND gate 32 to a clock output 33 coupled to the shift register 15. The input I1 is also coupled to clock inputs of two D-type flip-flops 34 and 35. An output Q1 of flip-flop 34 is coupled to a second input of the AND gate 32, whereas an inverting output of the flip-flop 35 is coupled to a data output 36 that is coupled to the data input of the shift register 15.

The logic states of the two flip-flops 34 and 35 are controlled by a logic circuit comprising 3 NAND gates 37, being coupled to the input 12 of the data extractor.

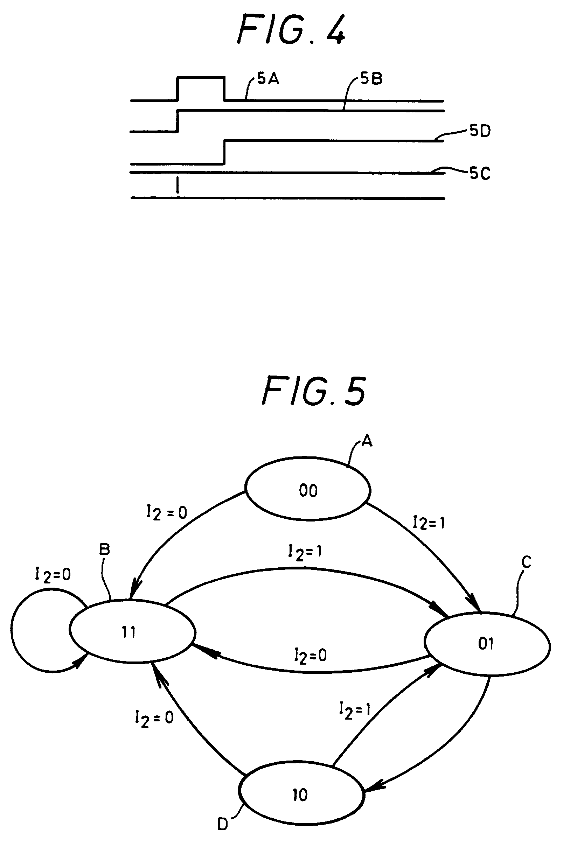

For an understanding of the operation of the data extractor circuit, the relative timing of the digital signals occurring in the circuit will be explained with reference to Fig.4, wherein the signal wave forms are plotted against time on the horizontal axis. The signal 5A illustrates a clock pulse provided from EXCLUSIVE OR gate 24 at input I1; the signal 5B illustates a corresponding output signal generated from output Q1 from the flip-flop 34 when the signal DATA (36) output from the flip-flop 35 in response to the clock pulse at I1 represents valid data. The signal 5C illustrates the signal DATA (36) and the signal 5D represents the signal CK (33).

The operation of the logic circuit of Fig.3 is represented by the state diagram shown in Fig. 5, wherein the two figures shown in the four bubbles A to D represent respectively logic states of the two outputs Q1 and Q2 of the flip-flops 34 and 35, and the arrows indicate transitions between the respective logic states that occur in response to the indicated logic value applied at input I2 during receipt of a clock pulse on input I1. It will be appreciated from Fig. 4 that the change in state of the flip-flops 34 and 35 occurs on the rising edge of the clock pulse of wave form 5A, whereas clocking of the data into the shift register 15 occurs on the rising edge of the wave form 5D when the data in flip-flops 34 and 35 is stable.

From Fig. 5 it will be seen that the logic state A corresponds to an initial state that cannot occur during continued operation of the data extractor, whereas states B C and D represent possible switched states of the flip-flops 34 and 35 during receipt of an incoming signal. From any of the given states, receipt of the signal 0 at input I2 will cause the flip-flops to be clocked to state B causing a logic 0 to be presented on output 36, together with a clock pulse on output 33. Upon the first clock pulse at input I1 after the logic level at input I2 goes to 1, the flip-flops will be clocked to state C. In this state the logic level 0 is provided at output 36, but no clock pulse is provided at output 33, so that there is no data output to the shift register 15. Upon receipt of the second clock pulse at input I1 whilst the input at I2 remains at I, the flip-flops 34 and 35 will be clocked to state D, wherein a logic level 1 is provided at the output 36 together with a corresponding clock pulse at output 33.

Thus it will be seen that the device as described provides a simple and reliable means for decoding bi-phase mark encoded serial data at variable repetition rates.

It will be appreciated that various alterations and modifications may be made to the device as described without departing from the scope of the invention. Thus, although the arrangement is particularly suited to the decoding of linear time code signals encoded as a bi-phase mark signal, the general concept of the invention could be applied to any signal that must be decoded by descriminating long and short periods between transitions, wherein the scale of the long and short periods of the signal may be subjected to unknown variations with time.

## Claims

1. A device for use in decoding a data signal of the kind which is divided into short and long periods between distinct transitions in state of the signal, comprising means (2,3) for detecting transitions in the signal state, means (4) coupled to said detecting means (2,3) for providing an output signal having a value proportional to the period between consecutive signal transitions, means (6) for providing a reference value representing the mean of a short and a long period of said signal, means (5) for comparing the value of said proportional output signal with said reference value and for scaling (9) the proportional value by a factor determined in accordance with the relationship between the said proportional and reference values, in order to increase the value of a said proportional signal corresponding to a short period and to reduce the value of a said proportional signal corresponding to a long period, in each case to a value corresponding to the mean of a short and a long period and means (13) for processing the said scaled values to derive said reference value.

2. A device as claimed in Claim 1, wherein said processing means comprises a low pass filter (13) for filtering said scaled values to remove short term variations therein and to provide an average of the filtered signals.

3. A device as claimed in Claim 1 or 2, wherein an output of said comparing means (5) is coupled to a data extracting circuit (14) arranged to recognise a long period of said data signal as a first logic value and two consecutive short periods of said data signal as a second logic value.

4. A device as claimed in Claim 3 wherein said data extracting circuit comprises a first input (I1) coupled to an output of said transition detecting means (2,3), a second input (I2) coupled to said output to said comparing means (5), and a logic circuit (31-39) providing a data output (36) at which are presented data values determined by the relative timing of signal pulses applied at said first and second inputs.

5. A device according to Claim 4, wherein said data extracting circuit further comprises a clock output (33) for signalling the presence of valid data at said data output (36).

6. A device according to Claim 5, wherein said data extracting circuit further comprises a pair of flip flops (34,35) having clock inputs coupled to said first input (I1) of the data circuit and having data inputs coupled to said second input (I2) of the data circuit via an array of logic gates (37-39) of which inputs are connected respectively to said second input (I2) of the data circuit and to logic outputs of said flip flops (34,25).

7. A device according to Claim 6, wherein said clock output (33) of said data extracting circuit is coupled via a logic gate (32) to a logic output of one flip flop (34) and to said first input (I1) of the data extracting circuit.

8. A device according to any one of Claims 1-7, wherein said means (4) for providing a proportional signal comprises a digital counter having a clock input and having a reset input coupled to an output of said transition detecting means.

9. A device according to any one of Claims 1-8, wherein said transition detecting means comprises a voltage comparator having respective signal inputs (1) for coupling to a source of a balanced signal and having an output coupled to a pair of cascaded flip flips (22-23) of which respective outputs are coupled to inputs of an exclusive OR gate (24).

10. A device according to Claim 2 or any one of Claims 3-9 as appended thereto wherein said low pass filter comprises an adder (29) having a first input, a second input and an output coupled in a loop to said second input; a shifter (28) having an input and an output coupled to the first input of the adder (29); and a subtracter (27) having a first input coupled to an output of said scaling means (9), a second input coupled to the output of said adder (29) and an output coupled to the input of said shifter (28)

## Patentansprüche

1. Vorrichtung zur Verwendung beim Decodieren eines Datensignals, das in kurze und lange Perioden zwischen ausgeprägten Zustandsänderungen des Signals unterteilt ist, mit einer Anordnung (2, 3) zum Erfassen von Änderungen des Signalzustandes, einer mit der Erfassungsanordnung gekoppelten Anordnung (4) zum Anliefern eines Ausgangssignals mit einem der Periode zwischen aufeinanderfolgenden Signaländerungen proportionalen Wert, einer Anordnung (6) zum Anliefern eines Bezugswertes, der das Mittel einer kurzen und einer langen Periode des Signals darstellt, einer Anordnung (5) zum Vergleichen des Wertes des proportionalen Ausgangssignals mit dem Bezugswert und zum Skalieren (9) des Proportionalwertes mit einem Faktor, der entsprechend der Beziehung zwischen dem Proportionalwert und dem Bezugswert bestimmt wird, um den Wert eines einer kurzen Periode entsprechenden Proportionalsignals zu vergrößern und den Wert eines einer langen Periode entsprechenden Proportionalsignals zu verkleinern, und zwar jeweils auf einen dem Mittel einer kurzen und einer langen Periode entsprechenden Wert, sowie mit einer Anordnung (13) zum Verarbeiten der skalierten Werte zwecks Ableitung des Bezugswertes.

2. Vorrichtung nach Anspruch 1, bei welcher die Verarbeitungsanordnung ein Tiefpaßfilter (13) zum Filtern der skalierten Werte aufweist, um darin vorhandene kurzzeitige Änderungen zu beseitigen und einen Mittelwert der gefilterten Signale bereitzustellen.

3. Vorrichtung nach Anspruch 1 oder 2, bei welcher ein Ausgang der Vergleicheranordnung (5) mit einer Datenextraktionsschaltung (14) gekoppelt ist, die so ausgelegt ist, daß sie eine lange Periode des Datensignals als einen ersten logischen Wert und zwei aufeinanderfolgende kurze Perioden des Datensignals als einen zweiten logischen Wert erkennt.

4. Vorrichtung nach Anspruch 3, bei welcher die Datenextraktionsschaltung einen mit einem Ausgang der Änderungserkennungsanordnung (2, 3) gekoppelten ersten Eingang (I1), einen mit dem Ausgangs der Vergleicheranordnung (5) gekoppelten zweiten Eingang (I2) und eine Logikschaltung (31 - 39) mit einem Datenausgang (36) aufweist, an dem Datenwerte dargestellt werden, die durch die relative Zeitfolge von Signalimpulsen bestimmt werden, die an den ersten und den zweiten Eingang angelegt werden.

5. Vorrichtung nach Anspruch 4, bei welcher die Datenextraktionsschaltung ferner einen Taktausgang (33) zum Signalisieren des Vorhandenseins von gültigen Daten an dem Datenausgang (36) aufweist.

6. Vorrichtung nach Anspruch 5, bei welcher die Datenextraktionsschaltung ferner mit zwei Flip-Flops (34, 35) versehen ist, die mit dem ersten Eingang (I1) der Datenschaltung gekoppelte Takteingänge und Dateneingänge aufweisen, die mit dem zweiten Eingang (I2) der Datenschaltung über eine Gruppe von logischen Gattern (37 - 39) gekoppelt sind, die Eingänge aufweisen, welche mit dem zweiten Eingang (I2) der Datenschaltung bzw. mit logischen Ausgängen der Flip-Flops (34, 35) verbunden sind.

7. Vorrichtung nach Anspruch 6, bei welcher der Taktausgang (33) der Datenextraktionsschaltung über ein logisches Gatter (32) mit einem logischen Ausgang eines Flip-Flops (34) und mit dem ersten Eingang (I1) der Datenextraktionsschaltung gekoppelt ist.

8. Vorrichtung nach einem der Ansprüche 1 bis 7, bei welcher die Anordnung (4) zum Anliefern eines Proportionalsignals einen digitalen Zähler aufweist, der mit einem Takteingang und einem Rücksetzeingang versehen ist, der mit einem Ausgang der Änderungserfassunganordnung gekoppelt ist.

9. Vorrichtung nach einem der Ansprüche 1 bis 8, bei welcher die Änderungserfassungsanordnung einen Spannungskomparator mit entsprechenden Signaleingängen (1) zum Ankoppeln an eine Quelle für ein abgeglichenes Signal und mit einem Ausgang aufweist, der mit zwei in Kaskade geschalteten Flip-Flops (22 - 23) aufweist, von denen entsprechende Ausgänge mit Eingängen einer exklusiven ODER-Schaltung (24) gekoppelt sind.

10. Vorrichtung nach Anspruch 2 oder einem darauf rückbezogenen der Ansprüche 3 bis 9, bei welcher das Tiefpaßfilter einen Addierer (29) mit einem ersten Eingang, einem zweiten Eingang und einem mit dem zweiten Eingang in einer Schleife gekoppelten Ausgang; eine Schiebeanordnung (28) mit einem Eingang und einem mit dem ersten Eingang des Addierers (29) gekoppelten Ausgang; sowie einen Subtrahierer (27) mit einem mit einem Ausgang der Skalieranordnung (9) gekoppelten ersten Eingang, einem mit dem Ausgang des Addierers (29) gekoppelten zweiten Eingang und einem mit dem Eingang der Schiebeanordnung (28) gekoppelten Ausgang aufweist.

## Revendications

1. Un dispositif à utiliser dans le décodage d'un signal de données du type qui est divisé en périodes courtes et longues entre différentes transitions de l'état du signal, comprenant un moyen (2, 3) pour détecter des transitions de l'état du signal, un moyen (4) couplé audit moyen de détection (2, 3) pour fournir un signal de sortie ayant une valeur proportionnelle à la période qui sépare des transitions de signal consécutives, un moyen (6) pour fournir une valeur de référence représentant la moyenne d'une période courte et d'une période longue dudit signal, un moyen (5) pour comparer la valeur dudit signal de sortie proportionnel à ladite valeur de référence et pour mettre à l'échelle (9) la valeur proportionnelle au moyen d'un coefficient déterminé selon le rapport entre lesdites valeurs proportionnelle et de référence, afin d'augmenter la valeur d'un signal proportionnel correspondant à une période courte et de réduire la valeur d'un signal proportionnel correspondant à une période longue, dans chaque cas à une valeur correspondant à la moyenne d'une période courte et d'une période longue et un moyen (13) pour traiter lesdites valeurs mises à l'échelle afin de dériver ladite valeur de référence.

2. Un dispositif selon la Revendication 1, dans lequel ledit moyen de traitement comprend un filtre passe-bas (13) pour filtrer lesdites valeurs mises à l'échelle afin d'en éliminer les variations à court terme et de fournir une moyenne des signaux filtrés.

3. Un dispositif selon la Revendication 1 ou 2, dans lequel une sortie du moyen de comparaison (5) est couplée à un circuit d'extraction de données (14) ayant pour fonction de reconnaître une période longue dudit signal de données comme une première valeur logique et deux périodes courtes consécutives dudit signal de données comme une seconde valeur logique.

4. Un dispositif selon la Revendication 3 dans lequel ledit circuit d'extraction de données comprend une première entrée (I1) couplée à une sortie du moyen de détection de transition (2, 3), une seconde entrée (I2) couplée à ladite sortie du moyen de comparaison (5), et un circuit logique (31-39) fournissant une sortie de données (36) à laquelle sont présentées des valeurs de données représentées par le cadencement relatif d'impulsions de signal appliquées auxdites première et seconde entrées.

5. Un dispositif selon la Revendication 4, dans lequel ledit circuit d'extraction de données comprend également une sortie d'horloge (33) pour signaler la présence de données correctes à la sortie de données (36).

6. Un dispositif selon la Revendication 5, dans lequel ledit circuit d'extraction de données comprend également une paire de bascules (34, 35) ayant des entrées d'horloge couplées à la première entrée (I1) du circuit de données et ayant des entrées de données couplées à la seconde entrée (I2) du circuit de données via un ensemble de portes logiques (37-39)) dont les entrées sont respectivement connectées à la seconde entrée (I2) du circuit de données et aux sorties logiques des bascules (34, 35).

7. Un dispositif selon la Revendication 6, dans lequel la sortie d'horloge (33) dudit circuit d'extraction de données est couplée via une porte logique (32) à une sortie logique d'une bascule (34) et à la première entrée (I1) du circuit d'extraction de données.

8. Un dispositif selon l'une ou l'autre des Revendications 1 à 7, dans lequel le moyen (4) pour fournir un signal proportionnel comprend un compteur numérique ayant une entrée d'horloge et ayant une entrée de remise à zéro couplée à une sortie dudit moyen de détection de transition.

9. Un dispositif selon l'une ou l'autre des Revendications 1 à 8, dans lequel ledit moyen de détection de transition comprend un comparateur de tension ayant des entrées de signaux (1) à coupler à une source de signal équilibré et ayant une sortie couplée à une paire de bascules en cascade (22-23) dont les sorties respectives sont couplées aux entrées d'une porte OU exclusif (24).

10. Un dispositif selon la Revendication 2 ou l'une ou l'autre des Revendications 3 à 9 annexées, dans lequel ledit filtre passe-bas comprend un additionneur (29) ayant une première entrée, une seconde entrée et une sortie couplée en boucle à ladite seconde entrée ; un décaleur (28) ayant une entrée et une sortie couplée à la première entrée de l'additionneur (29) ; et un soustracteur (27) ayant une première entrée couplée à une sortie dudit moyen de mise à l'échelle (9), une seconde entrée couplée à la sortie de l'additionneur (29) et une sortie couplée à l'entrée du décaleur (28).
